# EUROPEAN PATENT SPECIFICATION

(11) **EP 0 443 275 B1**
(45) Date of publication and mention of the grant of the patent: **28.09.1994**
(21) Application number: 90314435.0
(22) Date of filing: 28.12.1990
(51) Int. Cl.: H05K 3/40, H01R 13/04

(54) **Electrical edge contact member and a method of manufacturing same**
Elektrisches Kantenkontaktelement und Verfahren zur Herstellung
Elément avec contact d'arêtes électrique et procédé pour sa fabrication

(30) Priority: 19.01.1990 US 467720
(43) Date of publication of application: 28.08.1991
(73) Proprietor: THE WHITAKER CORPORATION, Wilmington, Delaware 19808 (US)
(72) Inventor: Grabbe, Dimitry G., Middletown, Pennsylvania 17057 (US)
(74) Representative: Warren, Keith Stanley

(56) References cited:
- DD-A- 267 146
- US-A- 4 843 190
- US-A- 4 855 868
- ELEKTRONIK, no. 17, August 26, 1983, Munich;GERHARD TAUBITZ "Zinn als Kontaktwerkstoff für Steckverbindungen" part 1, pages 39-42
- ELEKTRONIK, no. 7, 1978, Munich; PETER STAHLMüLLER, "Im Blickpunkt: Steckverbindungen" pages 46-50
- ELEKTRONIK, no. 7, 1978, Munich; KEIL AND TAUBITZ, "Neuer Oberflächenwerkstoff: Kann Palladium Gold ersetzen?" pages 51-52

## Description

This invention relates to electrical contact members and, more particularly, to an improved edge contact member in combination with a lead, e.g. for use in an integrated circuit chip burn-in connector, and to a method of producing such a contact member.

As part of the manufacturing process, integrated circuit chips typically go through a process of burn-in testing. To accomplish this testing, a special burn-in connector is utilized. This connector typically undergoes a large number of insertion/removal cycles of integrated circuit chips. Accordingly, the connector structure and the contact members in particular have to be designed to accommodate the large number of cycles.

Integrated circuit chips are typically manufactured with tin plated leads. This results in a contact physics or metallurgy problem. It is known that when two dissimilar metals come into rubbing contact, a thin layer of the softer metal will be deposited on the harder metal. Therefore, if the connector contact is gold plated, at the first insertion of an integrated circuit chip, a small amount of tin from the chip leads will be transferred as an extremely thin layer onto the gold of the connector contacts. By its very nature, a thin layer of this type is very stressed. The tin will then attempt to reduce its stress state by reacting with an available gas in its vicinity. Such gas will typically be oxygen, but it may also be sulphur, iodine, chlorine, etc. This reaction will result in the formation of a compound, which may be termed, using literary license, an "oxide layer". Irrespective of its exact chemical makeup, this layer either is non-conductive or semi-conductive and, as a result, the electrical resistance of the contact will change from several milliohms to several hundred milliohms, or higher. Accordingly, gold is not a desirable surface material for a contact of the character described herein. An alternative surface material for such a contact which is commonly used is tin plating over nickel. However, such a contact is subject to fretting corrosion (i.e. corrosion due to stress which forms a film on a soft material such as tin), which raises the contact resistance. Accordingly, an object of this invention is to provide an improved electrical contact member for use with a burn-in connector for integrated circuit chips which does not suffer from the aforenoted problems.

According to one aspect thereof the present invention consists in a substantially planar contact member in combination with a lead, as defined in claim 1.

According to another aspect thereof the present invention consists in a method of producing a substantially planar contact member, as defined in claim 10.

There are described in ELEKTRONIK, No. 7, 1978, Munich, PETER STAHLMÜLLER, "Im Blickpunkt: Steckverbindungen" pages 46-50 methods of plating electrical terminals for connection to leads with layers of metals which do not form solid solutions with the metals of the leads.

Embodiments of the invention will now be described by way of example with reference to the accompanying drawings, in which:
FIGURE 1 is a cross-sectional view through an illustrative connector assembly in which an electrical contact member constructed in accordance with an embodiment of this invention may be utilized;
FIGURE 2 is an enlarged view of an electrical contact member for use in the assembly shown in Figure 1 and which is constructed according to said embodiment of this invention;
FIGURE 3 is an enlarged cross-sectional view taken along the line 3-3 in Figure 2;
FIGURE 4 is an enlarged cross-sectional view of another embodiment taken along the line 3-3 in Figure 2; and
FIGURE 5 is an enlarged cross-sectional view of a further embodiment taken along the line 3-3 in Figure 2.

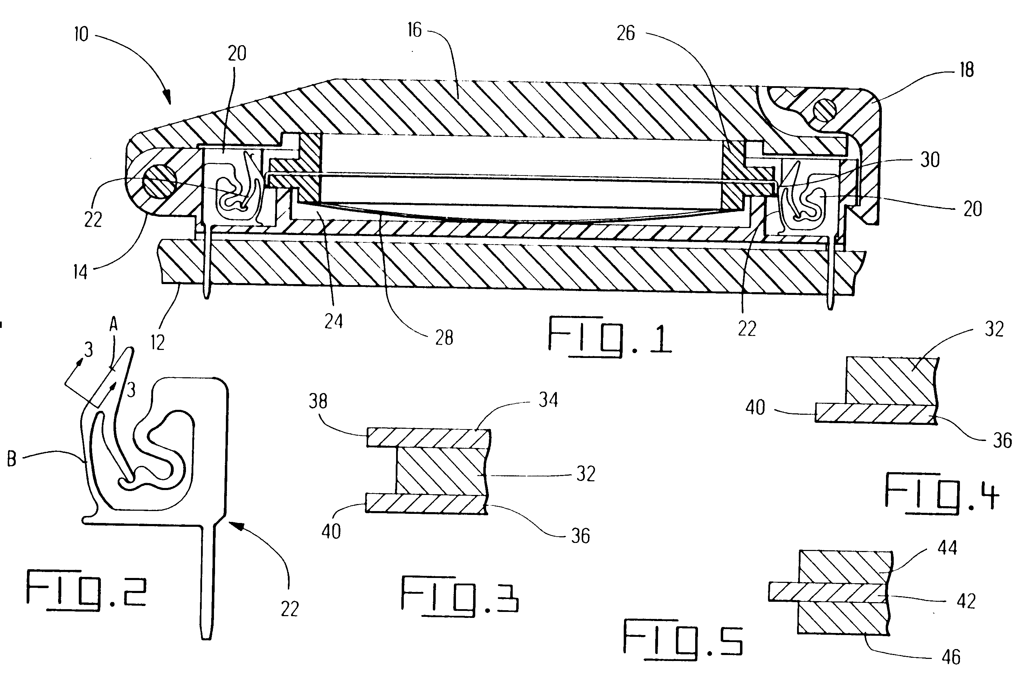

Referring to the drawings, Figure 1 shows a connector assembly, designated generally by the reference numeral 10, mounted on a printed circuit board 12 and in which a contact according to embodiments of this invention may be utilized. The connector assembly 10 is of the type utilized for burn-in testing of an integrated circuit chip and includes, generally, a body portion 14, a hinged cover member 16, and a latch member 18 for releasably securing the cover member 16 to the body portion 14 in a closed position. The body portion 14 is formed with a plurality of cavities 20, each for holding a single electrical contact member, shown at 22. The cavities 20 are arranged around the periphery of a central pocket 24, sized so as to accept an integrated circuit chip package 26. Within the bottom of the pocket 24 there is disposed a spring member 28 which is utilized to spring load the package 26 so that upon opening of the cover member 16, the package 26 is partially ejected. The package 26 is formed with leads along its periphery, illustratively depicted at 30. As discussed above, the leads 30 are typically tin plated. It is the tin plating, combined with the multiple insertions/removals, that can result in an oxide layer build-up on the edge of the contact member 22.

Figure 2 illustrates a contact member for use in the connector assembly 10. It should be understood that this invention is not limited to the particular contact member structure and shape shown in Figure 2, which is depicted for illustrative purposes only. What is important is that the contact member 22 is generally planar and makes contact with the lead 30 of the integrated circuit chip package 26 along its edge in a defined region which may be considered to extend from the point labeled A in Figure 2 to the point labeled B in Figure 2.

As discussed above, certain materials are inappropriate for multiple insertion/removal rubbing contact with tin plated leads. It has been found that certain hard metals, such as for example, stainless steel or Watts type nickel, resist the deposition thereon of a layer of tin. Thus, these materials do not form a solid solution with the soft tin. However, these harder materials, by themselves, are not appropriate materials for making a contact member such as that shown in Figure 2 because they do not exhibit inherent springiness, which is a requirement for the contact member 22. Accordingly, this embodiments of this invention involve forming a contact member from a composite material (i.e., a laminate) where at least one layer is of a material having good spring properties, such as, for example, beryllium copper or beryllium nickel, and at least one layer is a deposition-resisting material such as, for example, stainless steel.

Figure 3 illustrates a first embodiment of this invention wherein the contact member 22 is formed as a laminate of a core member 32 of the material having good spring properties with cladding 34, 36 of the deposition-resisting material on opposite surfaces thereof. In accordance with this invention, and as shown in Figure 3, the core member 32 is recessed from the cladding 34, 36 along at least the defined region between the points A and B. This leaves the exposed edges 38, 40 of the cladding material to act as an electrical contact, while the core 32 member provides the necessary spring property for the contact member. The tin transfer problem previously described with respect to gold is greatly diminished in the case of nickel or stainless steel as the cladding material, due to the fact that the metal transfer effect or cold welding to these materials is notoriously poor. Therefore, with any degree of wiping during the insertion/removal cycles, the effect of the tin transfer will be negligible. While the initial contact resistance of such a composite material will be higher than that of tin or gold, it will be a stable resistance and therefore much more acceptable for the burn-in process.

To manufacture the contact member shown in Figure 3, initially there must be formed a laminate of cladding on a core member. As previously described, the core member should have good spring properties and may illustratively be beryllium copper or beryllium nickel. The cladding material should have the property that it does not form a solid solution with the soft metal of the integrated circuit chip leads. Stainless steel of the 300 or 400 series or Carpenter Alloy #20 are appropriate cladding materials when the integrated circuit chip package leads are tin plated. Cladding of stainless steel on beryllium nickel or beryllium copper may be accomplished in a known manner by providing a sandwich of the materials where the abutting surfaces have been abraded and then rolling and annealing the sandwich until the desired thickness is attained. The thickness of the cladding may be as little as 0.00254 cm (0.001 inch) and as high as 0.0127 cm (0.005 inch). In addition to the foregoing, one can also produce cladding by electroplating both surfaces of the core material with a Watts type nickel, which can be made in hardnesses up to Vickers 600. Thus, a planar sheet of composite material is formed, from which a contact member blank is then stamped.

To recess the core material from the cladding, the contact member blank is either immersed in or sprayed with an etching solution. The etching solution should have the property that it does not attack the cladding material, but only etches the core material. Illustrative etching solutions for use with stainless steel cladding on a beryllium nickel or beryllium copper core are ferric chloride, ammonium persulfate and chromic acid. The etching is allowed to proceed until the core metal recedes from the stamped edge surface for a distance of at least 0.00127 cm (0.0005 inch), and perhaps as much as 0.00127 cm (0.005 inch). According to this embodiment, it is only necessary that the core material be recessed along the defined region of the edge where contact is made (i.e., between the points A and B). How much of the edge is recessed is determined by how much of the contact member is immersed in or sprayed with the etching solution.

Figure 4 illustrates an alternate embodiment for the contact member 22. In this embodiment, the core member 32 is only provided with the cladding 36 on one surface thereof. The materials and manufacturing steps to form the contact member shown in Figure 4 are the same as those used to form the contact member shown in Figure 3, with the exception that the cladding 34 is eliminated.

Figure 5 illustrates a further embodiment of the contact member 22. In the embodiment shown in Figure 5, the contact member blank is formed with a layer of the deposition-resisting material 42 sandwiched between two layers 44, 46 of the spring material. In the embodiment shown in Figure 5, the formation of the contact member blank is limited in that electroplating of the layer 42 of deposition-resisting material on the spring material is not possible. Therefore, when manufacturing the embodiment shown in Figure 5, the above-described process of rolling and annealing is preferred. The remainder of the manufacturing steps remain the same.

Accordingly, there have been described improved edge contact members and methods of manufacturing same. While illustrative embodiments of the present invention have been disclosed herein, it will be apparent to those of ordinary skill in the art that various modifications and adaptations to those embodiments are possible and it is only intended that the present invention be limited by the scope of the appended claims. Thus, the present invention contemplates a contact member formed as a laminate, where the number and order of the layers may be chosen to suit the particular application.

## Claims

1. A substantially planar contact member (22) in combination with a lead having at least a contact surface formed of a metal which is softer than that of the contact member (22), the contact member (22) providing an electrical connection along a defined region (38,40) of its edge with the contact surface of the lead;
characterized in that the contact member (22) is comprised of a laminate formed of at least one layer (32,44,46) of a first material having inherent springiness and at least one layer (34,36,42) of an electrically conductive second material having the property that it does not form a solid solution with said softer metal;
said at least one layer (32,44,46) of said first material being recessed with respect to said at least one layer (34,36,42) of said second material along at least said defined edge region (38,40).

2. A contact member (22) according to claim 1, characterized in that said at least one layer (32,44,46) of said first material is recessed in the range from about 0.00127cm (0.0005 inch) to about 0.0127 cm (0.005 inch).

3. A contact member (22) according to claim 1, characterized in that said first material is beryllium copper.

4. A contact member (22) according to claim 1, characterized in that said first material is beryllium nickel.

5. A contact member (22) according to claim 1, characterized in that said first material is spring steel.

6. A contact member (22) according to claim 1, characterized in that said second material is stainless steel.

7. A contact member (22) according to claim 1, characterized in that said second material is nickel.

8. A contact member (22) according to claim 1, characterized in that said laminate includes a core member (32,44,46) formed of a single layer of said first material and conductive cladding (36) of said second material on one surface of said core member (32).

9. A contact member (22) according to claim 8, characterized in that said laminate further includes conductive cladding (34) of said second material on the opposite surface of said core member (32).

10. A method of producing a substantially planar contact member (22) providing an electrical connection along a defined region (38,40) of its edge with a contact surface of a lead, said contact surface being formed of a metal which is softer than that of the contact member (22), characterized by the steps of:
providing a contact member blank formed as a laminate comprising at least one layer (32,44,46) of a first material having inherent springiness and at least one layer (34,36,42) of an electrically conductive second material having the property that it does not form a solid solution with said softer metal;
recessing said at least one layer (32,44,46) of the first material with respect to said at least one layer (34,36,42) of the second material along at least said defined edge region (38,40); and
connecting the contact surface of the lead to said defined edge region (38,40) of the contact member blank.

## Patentansprüche

1. Im wesentlichen ebenes Kontaktelement (22) in Verbindung mit einem Leiter, der wenigstens eine Kontaktoberfläche hat, die aus einem Metall gebildet ist, das weicher ist als dasjenige des Kontaktelements (22), wobei das Kontaktelement (22) eine elektrische Verbindung längs eines definierten Bereichs (38, 40) seiner Kante mit der Kontaktoberfläche des Leiters bildet,
dadurch **gekennzeichnet**,
daß das Kontaktelement (22) aus einem Laminat besteht, das aus wenigstens einer Schicht (32, 44, 46) eines ersten Materials gebildet ist, das inhärente Federeigenschaft hat, und wenigstens einer Schicht (34, 36, 42) eines elektrisch leitfähigen zweiten Materials, das die Eigenschaft hat, daß es nicht eine feste Lösung mit dem weicheren Metall bildet,
wobei die wenigstens eine Schicht (32, 44, 46) des ersten Materials in bezug auf die wenigstens eine Schicht (34, 36, 42) des zweiten Materials längs wenigstens des definierten Kantenbereichs (38, 40) zurückgesetzt ist.

2. Kontaktelement (22) nach Anspruch 1, dadurch **gekennzeichnet**, daß die wenigstens eine Schicht (32, 44, 46) des ersten Materials in dem Bereich von etwa 0,00127 cm (0,0005 Zoll) bis etwa 0,0127 cm (0,005 Zoll) zurückgesetzt ist.

3. Kontaktelement (22) nach Anspruch 1, dadurch **gekennzeichnet**, daß das erste Material Beryllium-Kupfer ist.

4. Kontaktelement (22) nach Anspruch 1, dadurch **gekennzeichnet**, daß das erste Material Beryllium-Nickel ist.

5. Kontaktelement (22) nach Anspruch 1, dadurch **gekennzeichnet**, daß das erste Material Federstahl ist.

6. Kontaktelement (22) nach Anspruch 1, dadurch **gekennzeichnet**, daß das zweite Material rostfreier Stahl ist.

7. Kontaktelement (22) nach Anspruch 1, dadurch **gekennzeichnet**, daß das zweite Material Nickel ist.

8. Kontaktelement (22) nach Anspruch 1, dadurch **gekennzeichnet**, daß das Laminat ein Kernelement (32, 44, 46) aufweist, das aus einer einzigen Schicht des ersten Materials gebildet ist, und eine leitfähige Beschichtung (36) aus dem zweiten Material auf einer Oberfläche des Kernelements (32).

9. Kontaktelement (22) nach Anspruch 8, dadurch **gekennzeichnet**, daß das Laminat ferner eine leitfähige Beschichtung (34) aus dem zweiten Material an der entgegengesetzten Oberfläche des Kernelements (32) aufweist.

10. Verfahren zum Herstellen eines im wesentlichen ebenen Kontaktelements (22), das eine elektrische Verbindung längs eines definierten Bereichs (38, 40) seiner Kante mit einer Kontaktoberfläche eines Leiters bildet, wobei die Kontaktoberfläche aus einem Metall gebildet ist, das weicher ist als dasjenige des Kontaktelements (22), **gekennzeichnet** durch die Schritte:
- Zurverfügungstellen eines Kontaktelementrohlings, der aus einem Laminat gebildet wird, das wenigstens eine Schicht (32, 44, 46) eines ersten Materials aufweist, das inhärente Federeigenschaft hat, und wenigstens eine Schicht (34, 36, 42) eines elektrisch leitfähigen zweiten Materials, das die Eigenschaft hat, daß es nicht eine feste Lösung mit dem weicheren Metall bildet,
- Zurücknehmen der wenigstens einen Schicht (32, 44, 46) des ersten Materials in bezug auf die wenigstens eine Schicht (34, 36, 42) des zweiten Materials längs wenigstens des definierten Kantenbereichs (38, 40), und
- Verbinden der Kontaktoberfläche des Leiters mit dem definierten Kantenbereich (38, 40) des Kontaktelementrohlings.

## Revendications

1. Elément de contact (22) sensiblement plan en combinaison avec un conducteur ayant au moins une surface de contact formée d'un métal qui est plus tendre que celui de l'élément de contact (22), l'élément de contact (22) réalisant une connexion électrique le long d'une zone définie (38, 40) de son chant avec la surface de contact du conducteur**;**
caractérisé en ce que l'élément de contact (22) est constitué d'un stratifié formé d'au moins une couche (32, 44, 46) d'une première matière ayant une flexibilité naturelle et d'au moins une coucbe (34, 36, 42) d'une seconde matière électriquement conductrice ayant pour propriété de ne pas former une solution solide avec ladite matière plus tendre ;
ladite, au moins une, couche (32, 44, 46) de ladite première matière étant en retrait par rapport à ladite, au moins une, couche (34, 36, 42) de ladite seconde matière le long au moins de ladite zone de chant définie (38, 40).

2. Elément de contact (22) selon la revendication 1, caractérisé en ce que ladite, au moins, couche (32, 44, 46) de ladite première matière est en retrait dans la plage d'environ 0,00127 cm (0,0005 inch) à environ 0,0127 cm (0,005 inch).

3. Elément de contact (22) selon la revendication 1, caractérisé en ce que ladite première matière est du cuivre au béryllium.

4. Elément de contact (22) selon la revendication 1, caractérisé en ce que ladite première matière est du nickel au béryllium.

5. Elément de contact (22) selon la revendication 1, caractérisé en ce que ladite première matière est de l'acier à ressort.

6. Elément de contact (22) selon la revendication 1, caractérisé en ce que ladite seconde matière est de l'acier inoxydable.

7. Elément de contact (22) selon la revendication 1, caractérisé en ce que ladite seconde matière est du nickel.

8. Elément de contact (22) selon la revendication 1, caractérisé en ce que ledit stratifié comprenant un élément d'âme (32, 44, 46) formé d'une seule couche de ladite première matière et un revêtement conducteur (36) de ladite seconde matière sur une surface dudit élément d'âme (32).

9. Elément de contact (22) selon la revendication 8, caractérisé en ce que ledit stratifié comprend en outre un revêtement conducteur (34) de ladite seconde matière sur la surface opposée dudit élément à d'âme (32).

10. Procédé de production d'un élément de contact (22) sensiblement plan réalisant une connexion électrique le long d'une zone définie (38, 40) de son chant avec une surface de contact d'un conducteur, ladite surface de contact étant formée d'un métal qui est plus tendre que celui de l'élément de contact (22), caractérisé par les étapes qui consistent :
à utiliser un flan d'élément de contact réalisé sous la forme d'un stratifié comprenant au moins une couche (32, 44, 46) d'une première matière ayant une flexibilité naturelle et au moins une couche (34, 36, 42) d'une seconde matière électriquement conductrice ayant pour propriété de ne pas former une solution solide avec ledit métal plus tendre ;
à mettre en retrait ladite, au moins une, couche (32, 44, 46) de la première matière par rapport à ladite, au moins une, couche (34, 36, 42) de la seconde matière le long au moins de ladite zone de chant définie (38, 40) ; et
à connecter la surface de contact du conducteur à ladite zone de champ définie (38, 40) du flan de l'élément de contact.
